# EUROPÄISCHE PATENTSCHRIFT

(11) **EP 1 095 377 B1**
(45) Veröffentlichungstag und Bekanntmachung des Hinweises auf die Patenterteilung: **07.05.2003**
(21) Anmeldenummer: 99942725.5
(22) Anmeldetag: 01.07.1999
(51) Int. Cl.: G11C 11/22

(54) **FeRAM-ANORDNUNG**
FERROELECTRIC RAM ARRANGEMENT
ENSEMBLE MEMOIRE VIVE FERROELECTRIQUE

(30) Priorität: 08.07.1998 DE 19830569
(43) Veröffentlichungstag der Anmeldung: 02.05.2001
(73) Patentinhaber: Infineon Technologies AG, 81669 München (DE)
(72) Erfinder: HINTERMAIER, Frank, D-81547 München (DE); SCHINDLER, Günther, D-80802 München (DE); HARTNER, Walter, D-81829 München (DE)
(74) Vertreter: Ginzel, Christian
(86) Internationale Anmeldenummer: DE9901905
(87) Internationale Veröffentlichungsnummer: WO00003395

(56) Entgegenhaltungen:
- EP-A- 0 720 172
- US-A- 5 155 573
- US-A- 5 189 594
- US-A- 5 291 436
- US-A- 5 495 438

## Beschreibung

Die vorliegende Erfindung betrifft eine FeRAM-(Ferroelektrische Random-Access-Memory- bzw. ferroelektrische Schreib-Lese-Speicher-)Anordnung mit einer Vielzahl von Speicherzellen, deren jede einen Auswahltransistor und eine Kondensatoreinrichtung mit ferroelektrischem Dielektrikum aufweist.

Bekanntlich wird in FeRAM-Anordnungen Information durch Polarisation im ferroelektrischen Dielektrikum der Kondensatoren von Speicherzellen gespeichert. Dabei wird ausgenutzt, daß ferroelektrische Dielektrika eine Hysterese haben, so daß bei anliegender Spannung "null Information entsprechend den vorliegenden beiden Polarisationszuständen dauerhaft gespeichert werden kann.

Um die Polarisation und damit auch die Information von dem einen Zustand in den anderen Zustand umzuschalten, muß eine gewisse Mindestspannung, die sogenannte Koerzitivspannung Vc, an den Kondensator angelegt werden.

Aus US 5,291,436 ist eine FeRAM-Anordnung mit dem Merkmalen des Oberbegriffs des Anspruchs 1 bekannt.

Um die Dichte der zu speichernden Information in einem ferroelektrischen Speicher zu erhöhen, wird darin vorgeschlagen, auf einer Seite des ferroelektrischen Dielektrikums wenigstens zwei Elektroden vorzusehen. Dadurch läßt sich mehr Information in den ferroelektrischen Speicher einschreiben.

Einen anderen Weg beschreitet die US 5,495,438, bei der zwei ferroelektrische Kondensatoren mit unterschiedlichen Koerzitivspannungen parallel zu einem gemeinsamen Speicherkondensator geschaltet werden, der somit eine "synthetische" Hysteresecharakteristik aufweist, welche die Speicherung von Mehr-Bit-Daten gestattet.

Es ist allgemein das Bestreben, Speicheranordnungen mit möglichst geringem Platzbedarf/Speicherzelle zu schaffen. So ist es auch Aufgabe der vorliegenden Erfindung, eine FeRAM-Anordnung auszugeben, bei der für die Speicherung eines Bits möglichst wenig Platz benötigt wird.

Diese Aufgabe wird mit einer FeRAM-Anordnung gemäß Anspruch 1 gelöst.

Die Erfindung geht damit einen vom bisherigen Stand der Technik vollkommen abweichenden Weg: Anstelle die FeRAM-Speicherzelle aus Auswahltransistor und (Speicher-)Kondensator durch bestimmte technologische Maßnahmen möglichst klein zu gestalten, wie dies an sich zu erwarten wäre, ordnet sie jedem Auswahltransistor mehrere Kondensatoren zu. Weist eine Speicherzeile beispielsweise einen Auswahltransistor und zwei Kondensatoren auf, so vermag sie zwei Bits zu speichern. Gegenüber einer herkömmlichen Speicherzelle aus einem Auswahltransistor und einem Kondensator, mit dem ein Bit gespeichert werden kann, ist damit der Platzbedarf zur Speicherung eines Bits praktisch halbiert, da die neuartige Speicherzelle kaum mehr Fläche beansprucht als die bestehende Speicherzelle.

Bei der erfindungsgemäßen FeRAM-Anordnung wird zunächst ausgenutzt, daß die Koerzitivspannung eines Kondensators vom Material des Dielektrikums sowie von dessen Schichtdicke abhängt. Durch entsprechende Auswahl von Material und/oder Schichtdicke ist es dann möglich, einem Auswahltransistor Kondensatoren mit unterschiedlichen Koerzitivspannungen parallel zueinander zuzuordnen, so daß in diese Kondensatoren unabhängig voneinander Information seriell eingeschrieben bzw. aus diesen Kondensatoren unabhängig voneinander seriell ausgelesen werden kann.

Zur näheren Erläuterung soll hierzu eine Speicherzelle mit einem Auswahltransistor und zwei Kondensatoren C1 und C2 betrachtet werden. Dabei sollen der Kondensator C1 eine Koerzitivspannung VC1 und der Kondensator C2 eine Koerzitivspannung VC2 haben, wobei VC1 < VC2 gilt, was durch entsprechende Materialwahl für die Dielektrika und/oder unterschiedliche Schichtdicken für die Dielektrika zu erreichen ist.

Beim Einschreiben von Information wird zuerst Information in den Kondensator C2 mit einer hohen Spannung U, die größer als VC2 ist, eingeschrieben. Bei diesem Einschreibvorgang wird auch eventuell im Kondensator C1 noch vorhandene Information zerstört. Anschließend wird an die Speicherzelle eine geringere Spannung angelegt, die zwischen VC1 und VC2 liegt. Durch diese geringere Spannung wird Information in den Kondensator C1 eingeschrieben, während jedoch der Kondensator C2 nicht mehr geschaltet wird. Damit kann in beiden Kondensatoren C1 und C2 unterschiedliche Information gespeichert werden.

Beim Auslesen von Information aus dieser Speicherzelle wird in umgekehrter Weise vorgegangen: Zuerst wird an die Speicherzelle eine geringe Spannung angelegt, die zwischen VC1 und VC2 liegt. Durch diese geringe Spannung wird der Kondensator C1 geschaltet, so daß sein Polarisationsstrom gemessen und damit die gespeicherte Polarisationsrichtung bestimmt werden kann. Anschließend wird eine hohe Spannung U angelegt, die größer VC2 ist. Damit wird die Information in entsprechender Weise aus dem Kondensator C2 ausgelesen. Ein Zurückschreiben der Information in die Kondensatoren ist sodann entsprechend dem obigen Vorgehen ohne weiteres möglich.

Durch das serielle Lesen und Schreiben ist die erfindungsgemäße FeRAM-Anordnung zwar langsamer als bestehende Anordnungen. Dieser Nachteil kann aber bei vielen Anwendungen in Kauf genommen werden, wenn ein besonders niedriger Platzbedarf angestrebt wird.

Um noch das obige Beispiel zu vertiefen, ist bei der erfindungsgemäßen FeRAM-Anordnung von Bedeutung, daß das ferroelektrische Dielektrikum des Kondensators C2 beim Anlegen einer Spannung unterhalb von VC2 nicht bereits zu einem großen Teil umpoiarisiert wird. Geringe Polarisationsverluste sind jedoch annehmbar, da der Kondensator C2 nur durch zwei Schaltvorgänge (Schreiben und Lesen) von dem Kondensator C1 beeinflußt werden kann. Es sei betont, daß bei guter Erfüllung dieser Voraussetzung auch mehr als zwei Kondensatoren mit "gestaffelter" Koerzitivspannung VC in einer Speicherzelle vorgesehen werden können, um mehr als zwei Bits je Auswahltransistor zu speichern.

Bevorzugte Dielektrika für die Kondensatoren sind SrBi₂Ta₂O₉(SBT), SrBi₂(Ta₁₋ₓNbₓ)₂O₉(SBTN) oder andere SBT-Derivate, PbZr₁₋ₓTiₓO₃(PZT) oder PbZr₁₋ₓTiₓLa_{y}O₃. Geeignete Schichtdicken des Dielektrikums betragen etwa 30-250 nm, in bevorzugter Weise ungefähr 180 nm. Für die Elektroden der Kondensatoren können Pt, Ir, Ru, Pd oder Oxide hiervon oder LaSrCoOₓ oder LaSnOₓ verwendet werden.

Die Kondensatoren können einen gemeinsamen Anschluß ("plug") mit gegehenenfalls gemeinsamen Speicherknoten aufweisen. Es ist aber auch möglich, daß die Kondensatoren verschiedene Speicherknoten und verschiedene gemeinsamen Platten besitzen und voneinander durch eine Zwischenisolierschicht aus beispielsweise Siliziumdioxid getrennt sind. Der bzw. die Speicherknoten können auch über einen Metallbügel mit dem Auswahltransistor verbunden sein.

Nachfolgend wird die Erfindung anhand der Zeichnungen näher erläutert. Es zeigen:
- Fig. 1: eine schematische Schnittdarstellung eines ersten Ausführungsbeispiels der Erfindung mit gemeinsamem Speicherknoten,
- Fig. 2: eine schematische Schnittdarstellung eines zweiten Ausführungsbeispiels der Erfindung mit getrennten Speicherknoten und getrennten gemeinsamen Platten und
- Fig. 3: eine schematische Schnittdarstellung eines dritten Ausführungsbeispiels der Erfindung mit einem Metallbügel zwischen einem gemeinsamen Speicherknoten der Kondensatoren und dem Auswahltransistor.

in den Figuren sind einander entsprechende Teile jeweils mit den gleichen Bezugszeichen versehen. Auch sind Isolierschichten zur besseren Übersichtlichkeit nicht gezeigt.

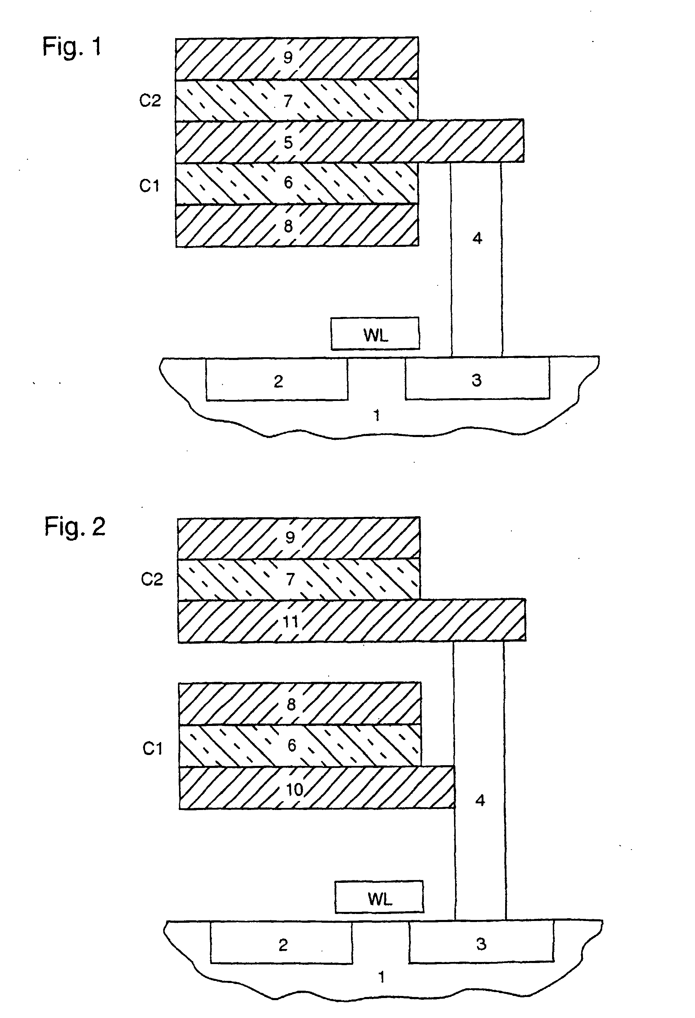

Fig. 1 zeigt schematisch in einem Silizium-Halbleiterkörper 1 einen Auswahltransistor mit Source 2 und Drain 3, zwischen denen in einer (nicht gezeigten) Isolierschicht aus beispielsweise Siliziumdioxid eine Wortleitung WL geführt ist. Drain 3 ist über einer ein gemeinsames Plug ("Stöpsel") 4 aus beispielsweise Metall, wie z.B. WolFeRAM oder Aluminium, oder dotiertem polykristallinem Silizium mit einem Speicherknoten 5 von zwei Stapel-Kondensatoren C1, C2 verbunden, die aus einer ersten gemeinsamen Platte 8, einem ersten Dielektrikum 6 und dem Speicherknoten 6 bzw. aus einer zweiten gemeinsamen Platte 9, einem zweiten Dielektrikum 7 und dem Speicherknoten 6 bestehen. Die Platten 8, 9 können miteinander verbunden sein.

Die Dielektrika 6, 7 sind so gewählt bzw. gestaltet, daß die Koerzitivspannung VC1 des Kondensators C1 verschieden von der Koerzitivspannung VC2 des Kondensators C2 ist. Dies kann wie eingangs erläutert wurde, durch unterschiedliche Schichtdikken und/oder unterschiedliche Materialien der Dielektrika 6, 7 erreicht werden. Geeignete Materialien sind z.B. SBT, SBTN, PZT und PLZT, während ein zweckmäßiger Schichtdickenbereich 30-250 nm, vorzugsweise etwa 180 nm beträgt. Selbstverständlich sind aber auch andere Schichtdicken möglich.

Beispielsweise haben bei einer Spannung von 3 V und einer Schichtdicke von 180 nm SBT und SBTN (mit einem Niob-Anteil von 28 %) Koerzitivspannungen VC von 0,65 V (SBT) bzw. 1 V (SBTN).

Geeignete Materialien für die Kondensator-Elektroden, also die gemeinsamen Platten 8, 9 und den Speicherknoten 5 sind Pt, Pd, Rh, Au, Ir, Ru, Oxide hiervon, LaSrCoOₓ und LaSuOₓ.

Möglich ist auch eine Variante, bei der eine gemeinsame Platte (wie der Speicherknoten 5) in der "Mitte" des Stapels vorgesehen ist und zwei Speicherknoten (entsprechend den Platten 8, 9) an das Plug 4 angeschlossen sind.

Die angegebenen Materialien gelten für alle Ausführungsbeispiele.

Fig. 2 zeigt ein Ausführungsbeispiel, bei dem die beiden Kondensatoren C1, C2 unterschiedliche Speicherknoten 11, 12, die mit dem Plug 4 verbunden sind, neben den Platten 8, 9 haben. Dabei sind die Kondensatoren voneinander durch eine nicht näher dargestellte Isolierschicht aus beispielsweise Siliziumdioxid getrennt.

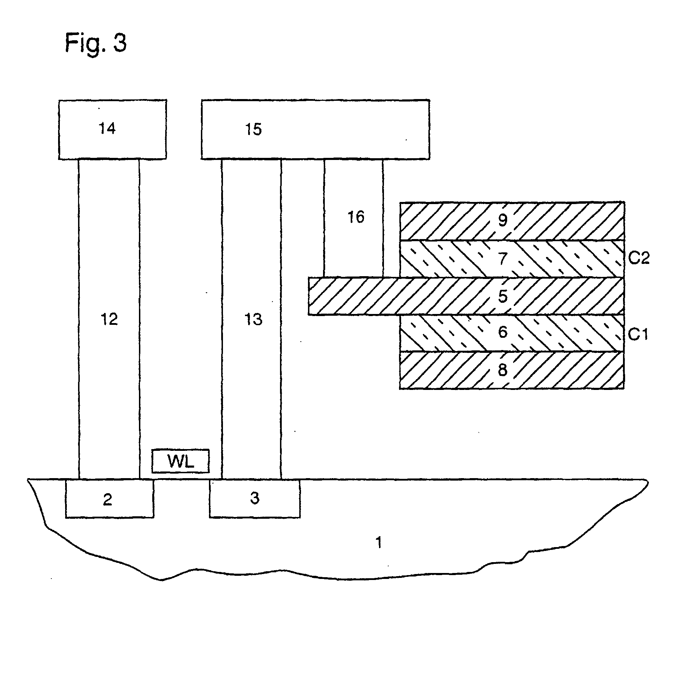

Fig. 3 zeigt ein Ausführungsbeispiel, bei dem ein gemeinsamer Speicherknoten 5 über einen Metallbügel aus einem Stöpsel 16 (beispielsweise aus dotiertem polykristallinem Silizium oder Aluminium) mit Drain 3 verbunden ist. Außerdem ist hier ein Kontakt 12 (aus gleichem Material wie Kontakt 13) zu einer Bitleitung 14 dargestellt. Die Kondensatoren C1, C2 dieses Ausführungsbeispiels können auch so abgewandelt werden, wie dies oben für die Variante zu Fig. 1 und für das Ausführungsbeispiel von Fig. 2 erläutert ist.

## Patentansprüche

1. FeRAM-Anordnung mit einer Vielzahl von Speicherzellen, deren jede einen Auswahltransistor (2, 3) und eine Kondensatoreinrichtung mit ferroelektrischem Dielektrikum aufweist, **dadurch gekennzeichnet, daß** die Kondensatoreinrichtung aus wenigstens zwei Kondensatoren (C1, C2) besteht, deren Koerzitivspannungen voneinander verschieden sind, wobei die wenigstens zwei Kondensatoren (C1, C2) übereinander mit dazwischen liegendem gemeinsamen Speicherknoten angeordnet sind, der über einen gemeinsamen Speicherknoten-Anschluss (4, 16) mit dem Auswahltransistor (2, 3) verbunden ist.

2. FeRAM-Anordnung nach Anspruch 1,
**dadurch gekennzeichnet,**
**daß** die Dielektrika (6, 7) der Kondensatoren (C1, C2) aus verschiedenen Materialien bestehen.

3. FeRAM-Anordnung nach Anspruch 1,
**dadurch gekennzeichnet,**
**daß** die Dielektrika (6, 7) der Kondensatoren (C1, C2) eine voneinander unterschiedliche Schichtdicke aufweisen.

4. FeRAM-Anordnung nach Anspruch 2 oder 3,
**dadurch gekennzeichnet,**
**daß** die Dielektrika (6, 7) der Kondensatoren (C1, C2) aus SrBi₂Ta₂O₉(SBT), SrBi₂(Ta₁₋ₓNbₓ)₂O₉ (SBTN) oder andere SBT-Derivate, PbZr₁₋ₓTiₓO₃(PZT) oder PbZr₁₋ₓTiₓLa_{y}O₃ bestehen.

5. FeRAM-Anordnung nach einem der Ansprüche 2 bis 4,
**dadurch gekennzeichnet,**
**daß** die Schichtdicke des Dielektrikums (6, 7) etwa 30 bis 250 nm beträgt.

6. FeRAM-Anordnung nach Anspruch 5,
**dadurch gekennzeichnet,**
**daß** die Schichtdicke etwa 180 nm beträgt.

7. FeRAM-Anordnung nach einem der Ansprüche 1 bis 6,
**dadurch gekennzeichnet,**
**daß** die Elektroden (5, 8, 9) der Kondensatoren (C1, C2) aus Pt, Pd, Rh, Au, Ir, Ru oder Oxiden hiervon oder LaSrCoOₓ oder LaSnOₓ bestehen.

8. FeRAM-Anordnung nach einem der Ansprüche 1 bis 7,
**dadurch gekennzeichnet,**
**daß** der Speicherknoten-Anschluss durch einen Metallbügel (16, 15, 13) gebildet wird.

9. FeRAM-Anordnung nach einem der Ansprüche 1 bis 8,
**dadurch gekennzeichnet,**
**daß** der Speicherknoten-Anschluss durch einen gemeinsamen Anschluß (4) gebildet wird.

## Claims

1. FeRAM arrangement having a multiplicity of memory cells, each of which has a selection transistor (2, 3) and a capacitor device with a ferroelectric dielectric, **characterized in that** the capacitor device comprises at least two capacitors (C1, C2) whose coercive voltages differ from one another, the at least two capacitors (C1, C2) being arranged one above the other with a common storage node situated in between which is connected via a common storage node connection (4, 16) to the selection transistor (2, 3).

2. FeRAM arrangement according to Claim 1,
**characterized**
**in that** the dielectrics (6, 7) of the capacitors (C1, C2) are composed of different materials.

3. FeRAM arrangement according to Claim 1,
**characterized**
**in that** the dielectrics (6, 7) of the capacitors (C1, C2) have a mutually different layer thickness.

4. FeRAM arrangement according to Claim 2 or 3,
**characterized**
**in that** the dielectrics (6, 7) of the capacitors (C1, C2) are composed of SrBi₂Ta₂O₉(SBT), SrBi₂(Ta₁₋ₓNbₓ)₂O₉ (SBTN) or other SBT derivatives, PbZr₁₋ₓTiₓO₃ (PZT) or PbZr₁₋ₓTiₓLa_{y}O₃.

5. FeRAM arrangement according to one of Claims 2 to 4,
**characterized**
**in that** the layer thickness of the dielectric (6, 7) is about 30 to 250 nm.

6. FeRAM arrangement according to Claim 5,
**characterized**
**in that** the layer thickness is about 180 nm.

7. FeRAM arrangement according to one of Claims 1 to 6,
**characterized**
**in that** the electrodes (5, 8, 9) of the capacitors (C1, C2) are composed of Pt, Pd, Rh, Au, Ir, Ru or oxides thereof or LaSrCoOₓ or LaSnOₓ.

8. FeRAM arrangement according to one of Claims 1 to 7,
**characterized**
**in that** the storage node connection is formed by a metal clip (16, 15, 13).

9. FeRAM arrangement according to one of Claims 1 to 8,
**characterized**
**in that** the storage node connection is formed by a common connection (4).

## Revendications

1. Mémoire vive ferroélectrique ayant une pluralité de cellules de mémoire, dont chacune a un transistor (2, 3) de sélection et un dispositif de condensateur à diélectrique ferroélectrique, **caractérisée en ce que** le dispositif de condensateur est constitué d'au moins deux condensateurs (C1, C2), dont les tensions coercitives sont différentes l'un de l'autre, les au moins deux condensateurs (C1, C2) étant disposés l'un au-dessus de l'autre avec entre eux un noeud de mémoire commun qui est relié au transistor (2, 3) de sélection par une borne (4, 16) commune de noeud de mémoire.

2. Mémoire vive ferroélectrique suivant la revendication 1,
**caractérisée**
**en ce que** les diélectriques (6, 7) des condensateurs (C1, C2) sont en des matériaux différents.

3. Mémoire vive ferroélectrique suivant la revendication 1,
**caractérisée**
**en ce que** les diélectriques (6, 7) des condensateurs (C1, C2) ont une épaisseur de couche différente l'une de l'autre.

4. Mémoire vive ferroélectrique suivant la revendication 2 ou 3,
**caractérisée**
**en ce que** les diélectriques (6, 7) des condensateurs (C1, C2) sont en SrBi₂Ta₂O₉(SBT), SrBi₂(Ta₁₋ₓNbₓ)₂O₉(SBT) ou en d'autres dérivés de SBT, en PbZr₁₋ₓTiₓO₃(PZT) ou PbZr₁₋ₓTiₓLa_{y}O₃.

5. Mémoire vive ferroélectrique suivant l'une des revendications 2 à 4,
**caractérisée**
**en ce que** l'épaisseur de couche du diélectrique (6, 7) est comprise entre environ 30 et 250 nm.

6. Mémoire vive ferroélectrique suivant la revendication 5,
**caractérisée**
**en ce que** l'épaisseur de la couche est d'environ 180 nm.

7. Mémoire vive ferroélectrique suivant l'une des revendications 1 à 6,
**caractérisée**
**en ce que** les électrodes (5, 8, 9) des condensateurs (C1, C2) sont en Pt, Pd, Rh, Au, Ir, Ru ou en oxydes de ceux-ci ou en LaSrCoOₓ ou en LaSnOₓ.

8. Mémoire vive ferroélectrique suivant l'une des revendications 1 à 7,
**caractérisée**
**en ce que** la borne du noeud de mémoire est formée par un étrier (16, 15, 13) métallique.

9. Mémoire vive ferroélectrique suivant l'une des revendications 1 à 8,
**caractérisée**
**en ce que** la borne du noeud de mémoire est formée par une borne (4) commune.
